# EUROPEAN PATENT SPECIFICATION

(11) **EP 1 227 912 B1**
(45) Date of publication and mention of the grant of the patent: **25.05.2005**
(21) Application number: 00947542.7
(22) Date of filing: 19.07.2000
(51) Int. Cl.: B24B 7/22, B24B 21/04, B24D 3/28, B24D 11/00

(54) **METHODS AND APPARATUSES FOR PLANARIZING MICROELECTRONIC SUBSTRATE ASSEMBLIES**
VERFAHREN UND VORRICHTUNG ZUM PLANARISIEREN VON MIKROELEKTRONISCHEM SUBSTRATENAUFBAU
PROCEDES ET APPAREILS D'APLANISSEMENT D'ASSEMBLAGES DE SUBSTRATS MICRO-ELECTRONIQUES

(30) Priority: 20.07.1999 US 356808
(43) Date of publication of application: 07.08.2002
(73) Proprietor: Micron Technology, Inc., Boise, ID 83707 (US)
(72) Inventor: SABDE, Gundu, M., Boise, ID 83716 (US); LEE, Wonchee, Boise, ID 83709 (US)
(74) Representative: Hirsch, Peter, Dipl.-Ing.
(86) International application number: PCT/US2000/019692
(87) International publication number: WO 2001/005555

(56) References cited:
- WO-A-97/11484
- US-A- 5 722 877
- US-A- 5 916 012
- US-A- 5 997 384
- PATENT ABSTRACTS OF JAPAN vol. 1998, no. 06, 30 April 1998 (1998-04-30) -& JP 10 034514 A (SANSHIN:KK), 10 February 1998 (1998-02-10)

## Description

### TECHNICAL FIELD

The present invention relates to methods and apparatuses for planarizing microelectronic substrate assemblies and, more particularly, to mechanical and/or chemical-mechanical planarization of such substrate assemblies using non-abrasive planarizing solutions and fixed-abrasive polishing pads.

### BACKGROUND OF THE INVENTION

Mechanical and chemical-mechanical planarizing processes (collectively "CMP") are used in the manufacturing of electronic devices for forming a flat surface on semiconductor wafers, field emission displays and many other microelectronic substrate assemblies. CMP processes generally remove material from a substrate assembly to create a highly planar surface at a precise elevation in the layers of material on the substrate assembly.

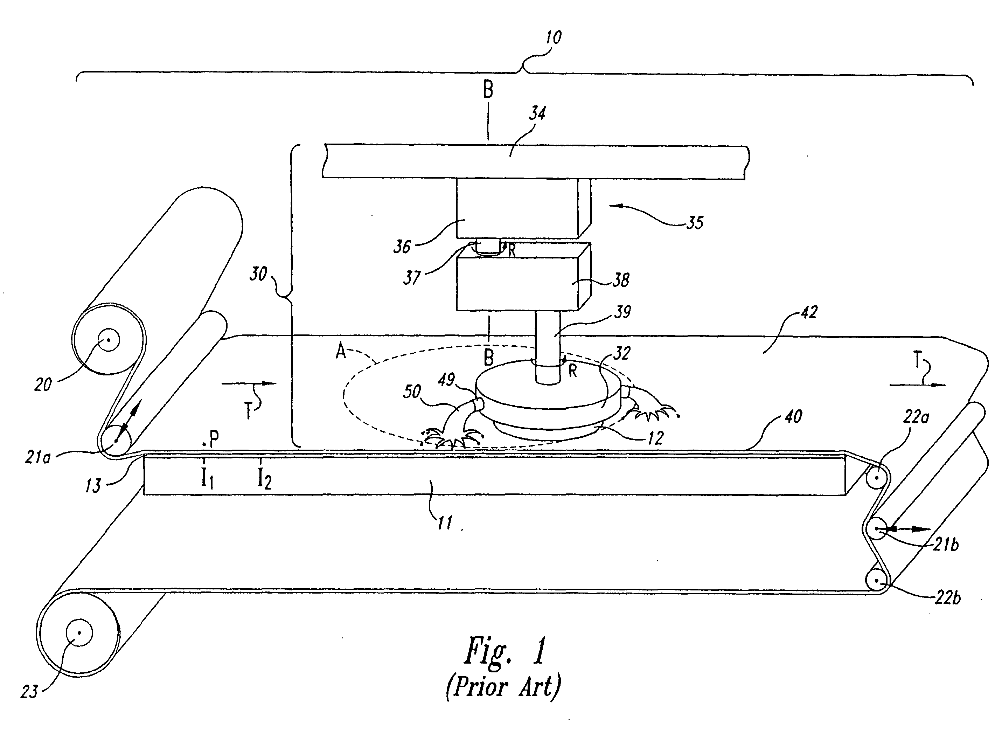

Figure 1 is a schematic isometric view of a web-format planarizing machine 10 for planarizing a microelectronic substrate assembly 12. The planarizing machine 10 has a table 11 with a rigid panel or plate to provide a flat, solid support surface 13 for supporting a portion of a web-format planarizing pad 40 in a planarizing zone "A." The planarizing machine 10 also has a pad advancing mechanism including a plurality of rollers to guide, position, and hold the web-format pad 40 over the support surface 13. The pad advancing mechanism generally includes a supply roller 20, first and second idler rollers 21a and 21b, first and second guide rollers 22a and 22b, and a take-up roller 23. As explained below, a motor (not shown) drives the take-up roller 23 to advance the pad 40 across the support surface 13 along a travel axis T-T. The motor can also drive the supply roller 20. The first idler roller 21a and the first guide roller 22a press an operative portion of the pad against the support surface 13 to hold the pad 40 stationary during operation.

The planarizing machine 10 also has a carrier assembly 30 to translate the substrate assembly 12 across the pad 40. In one embodiment, the carrier assembly 30 has a head 32 to pick up, hold and release the substrate assembly 12 at appropriate stages of the planarizing process. The carrier assembly 30 also has a support gantry 34 and a drive assembly 35 that can move along the gantry 34. The drive assembly 35 has an actuator 36, a drive shaft 37 coupled to the actuator 36, and an arm 38 projecting from the drive shaft 37. The arm 38 carries the head 32 via another shaft 39. The actuator 36 orbits the head 32 about an axis B-B to move the substrate assembly 12 across the pad 40.

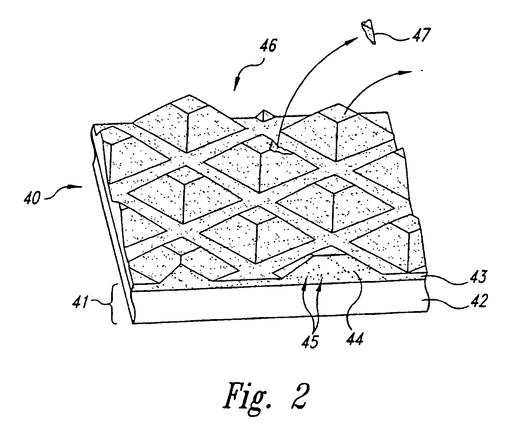

The polishing pad 40 may be a non-abrasive polymeric pad (*e.g*., polyurethane), or it may be a fixed-abrasive polishing pad in which abrasive particles are fixedly dispersed in a resin or another type of suspension medium. Figure 2, for example, is an isometric view of a fixed-abrasive polishing pad having a body 41 including a backing film 42 and a planarizing medium 43 on the backing film 42. The backing film 42 can be a thin sheet of Mylar® or other flexible, high-strength materials. The abrasive planarizing medium 43 generally includes a resin binder 44 and a plurality of abrasive particles 45 distributed throughout the resin binder 44. The planarizing medium 43 is generally textured to form a planarizing surface 46 having a plurality of truncated pyramids, cylindrical columns, or other raised features. The 3M Corporation of St. Paul, Minnesota, for example, manufactures several fixed-abrasive polishing pads having alumina, ceria or other abrasive particles fixedly bonded to a Mylar® backing film 42 by a resin binder.

Referring again to Figure 1, a planarizing fluid 50 flows from a plurality of nozzles 49 during planarization of the substrate assembly 12. The planarizing fluid 50 may be a conventional CMP slurry with abrasive particles and chemicals that etch and/or oxidize the surface of the substrate assembly 12, or the planarizing fluid 50 may be a "clean" non-abrasive planarizing solution without abrasive particles. In most CMP applications, abrasive slurries with abrasive particles are used on non-abrasive polishing pads, and non-abrasive clean solutions without abrasive particles are used on fixed-abrasive polishing pads.

In the operation of the planarizing machine 10, the pad 40 moves across the support surface 13 along the pad travel path T-T either during or between planarizing cycles to change the particular portion of the polishing pad 40 in the planarizing zone A. For example, the supply and take-up rollers 20 and 23 can drive the polishing pad 40 between planarizing cycles such that a point P moves incrementally across the support surface 13 to a number of intermediate locations I₁, I₂, etc. Alternatively, the rollers 20 and 23 may drive the polishing pad 40 between planarizing cycles such that the point P moves all the way across the support surface 13 to completely remove a used portion of the pad 40 from the planarizing zone A. The rollers may also continuously drive the polishing pad 40 at a slow rate during a planarizing cycle such that the point P moves continuously across the support surface 13. Thus, the polishing pad 40 should be free to move axially over the length of the support surface 13 along the pad travel path T-T.

CMP processes should consistently and accurately produce a uniform, planar surface on substrate assemblies to enable circuit and device patterns to be formed with photolithography techniques. As the density of integrated circuits increases, it is often necessary to accurately focus the critical dimensions of the photo-patterns to within a tolerance of approximately 0.1 µm. Focusing photo-patterns to such small tolerances, however, is difficult when the planarized surfaces of substrate assemblies are not uniformly planar. Thus, to be effective, CMP processes should create highly uniform, planar surfaces on substrate assemblies.

The planarity of the finished substrate surface is a function of several factors, one of which is the distribution of abrasive particles under the substrate assembly during planarization. In certain applications that use a non-abrasive pad and an abrasive slurry, the distribution of abrasive particles under the substrate assembly may not be uniform because the edge of the substrate assembly wipes the slurry off of the pad such that the center region of the substrate assembly does not consistently contact abrasive particles. The center region of the substrate assembly may accordingly have a different polishing rate than the edge region causing a center-to-edge polishing gradient across the substrate assembly.

Fixed abrasive polishing pads, like the one shown in Figure 2, are relatively new and have the potential to produce highly planar surfaces. The primary technical advance of fixed-abrasive pads is that the distribution of abrasive particles under the substrate assembly is not a function of the distribution of the planarizing solution because the abrasive particles are fixedly attached to the pad. Fixed abrasive pads accordingly provide a more uniform distribution of abrasive particles under the substrate assembly 12 than abrasive slurries on non-abrasive pads. Fixed-abrasive polishing pads, however, may scratch or otherwise produce defects on the finished substrate surface. The particular mechanism that causes scratching and defects is not completely understood, but it is expected that large pieces 47 of the fixed-abrasive planarizing medium 43 (see Figure 2) break away during planarization and scratch the substrate assembly 12. Fixed-abrasive pads may also produce defects because, unlike abrasive slurries in which the abrasive particles are mobile and can move with the slurry, the abrasive particles in fixed-abrasive pads do not roll or move with the substrate assembly. As such, minor peaks on the raised features of the planarizing surface 46 or disparities in the size or shape of the fixed-abrasive particles 45 may scratch the substrate surface. Therefore, even though fixed-abrasive pads are promising, they may scratch the finished substrate surface of microelectronic substrate assemblies or otherwise produce defects in the integrated circuits.

### SUMMARY OF THE INVENTION

The present invention relates to planarizing microelectronic substrate assemblies on fixed-abrasive polishing pads with non-abrasive planarizing solutions. One aspect of the invention is to deposit a lubricating planarizing solution without abrasive particles onto a fixed-abrasive polishing pad having a body, a planarizing surface on the body, and a plurality of abrasive particles fixedly attached to the body at the planarizing surface. The front face of a substrate assembly is pressed against the lubricating planarizing solution and at least a portion of the planarizing surface of the polishing pad. At least one of the polishing pad or the substrate assembly is then moved with respect to the other to impart relative motion therebetween. As the substrate assembly moves relative to the polishing pad, regions of the front face are separated from the abrasive particles in the polishing pad by a lubricant-additive in the planarizing solution. A method of planarizing a microelectronic device, a planarizing solution and the method of making same as well as a planarizing machine according to the state of the art are discribed in document WO 9711484.

In one particular application, separating the regions of the front face of the substrate assembly from the abrasive particles involves dissolving the lubricant-additive into a non-abrasive solution to form the lubricating planarizing solution, and then depositing the lubricating planarizing solution onto the polishing pad as the substrate assembly moves relative to the polishing pad. The lubricant-additive can be glycerol, polyethylene glycol, polypropylene glycol, CARBOGEL manufactured by B.F. Goodrich, polyvinyl alcohol, POLYOX manufactured by Union Carbide, or some other lubricating liquid. The concentration of the lubricant-additive in the non-abrasive solution is selected so that the lubricating planarizing solution has a viscosity of at least 4-100 cp, and more generally 10-20 cp. In operation, the lubricating planarizing solution provides a protective boundary layer between the front face of the substrate assembly and the abrasive planarizing surface to inhibit the fixed abrasive particles from overly abrading the substrate assembly. Thus, compared to planarizing solutions without the lubricant-additive, the lubricating planarizing solution is expected to reduce defects and scratches on the front face of the substrate assembly in fixed-abrasive planarization.

### BRIEF DESCRIPTION OF THE DRAWINGS

Figure 1 is a schematic isometric view of a planarizing machine in accordance with the prior art.
Figure 2 is a partial isometric view of a fixed-abrasive polishing pad in accordance with the prior art.
Figure 3 is a schematic isometric view of a web-format planarizing machine used in accordance with an embodiment of the invention.
Figure 4 is a schematic cross-sectional view of a lubricating planarizing solution further illustrating methods in accordance with an embodiment of the invention.

### DETAILED DESCRIPTION OF THE INVENTION

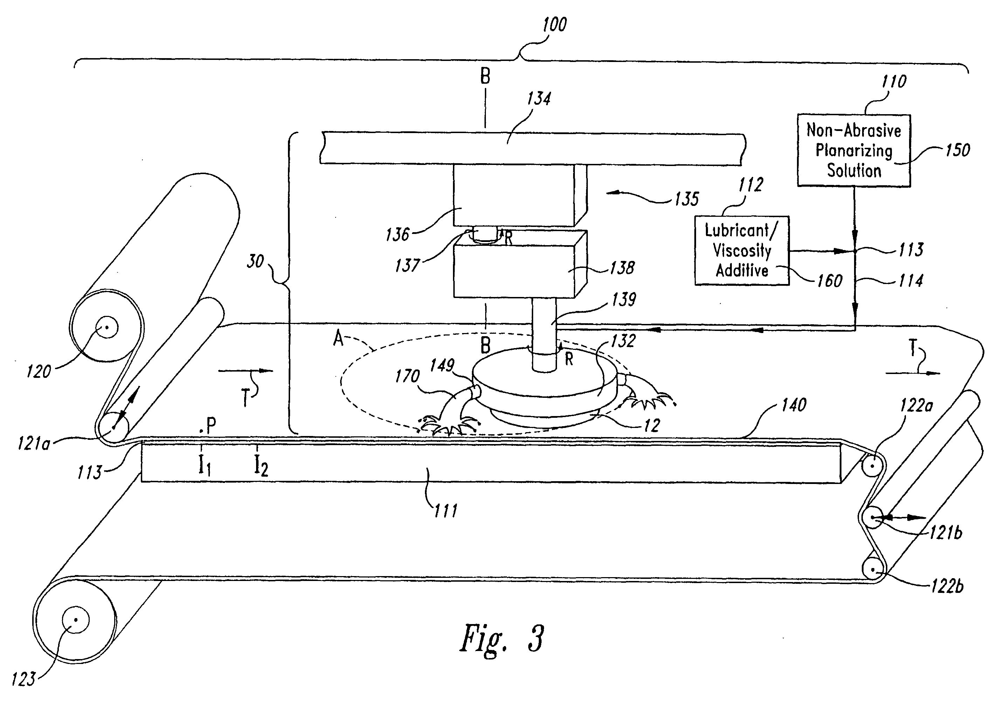

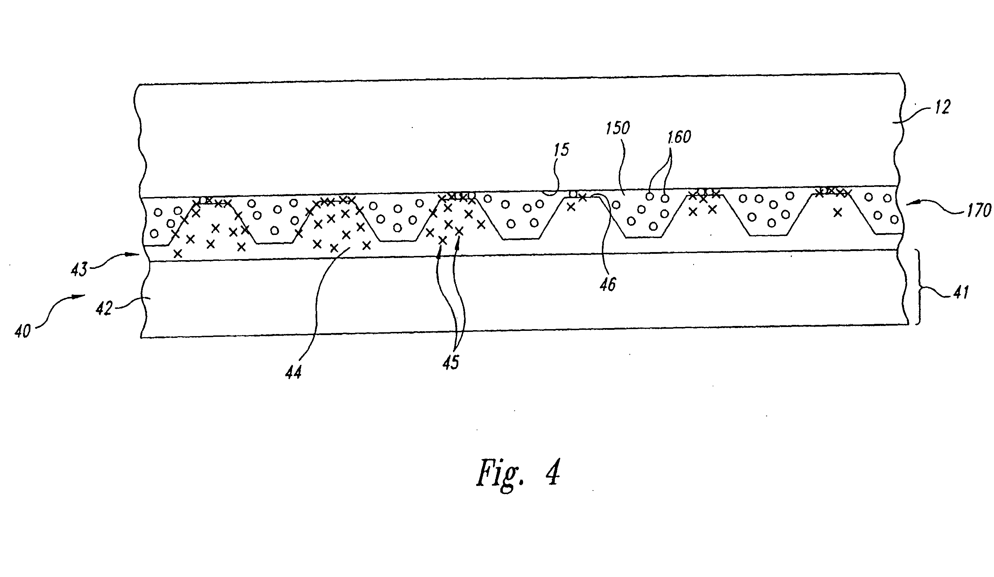

The present invention relates to planarizing microelectronic substrate assemblies on fixed-abrasive polishing pads with non-abrasive lubricating planarizing solutions. Several aspects and details of certain embodiments of this invention are described in detail below, and illustrated in Figures 3 and 4, to provide a thorough understanding of making and using these embodiments of the invention. It will be appreciated, however, that particular details may be omitted from some of the embodiments, or that there may be additional embodiments of the invention that are covered by the following claims.

Figure 3 is a schematic isometric view of a web-format planarizing machine 100 for planarizing a microelectronic substrate assembly 12 in accordance with an embodiment of the invention. The planarizing machine 100 includes a table 111 having a support surface 113, a carrier assembly 130 over the table 111, and a polishing pad 140 on the support surface 113. The table 111, support surface 113 and carrier assembly 130 can be substantially the same as those described above with reference to Figure 1. The polishing pad 140 is coupled to a pad advancing mechanism having a plurality of rollers 120, 121a, 121b, 122a, 122b and 123. The pad advancing mechanism can also be the same as that described above with reference to Figure 1. The planarizing machine 100 further includes a first container 110 holding a supply of a non-abrasive solution 150 and a second container 112 holding a supply of a lubricant-additive 160.

The non-abrasive solution 150 can be an aqueous planarizing solution containing water, oxidants, surfactants, and other non-abrasive materials. The non-abrasive solution 150 does not contain abrasive particles that are commonly used in abrasive CMP slurries (*e*.*g*., alumina, ceria, titania, titanium, silica or other abrasive particles). For example, the non-abrasive solution 150 can contain water and either ammonia or potassium hydroxide. The non-abrasive solution 150, more specifically, can include 65-99.9% of deionized water and 0.1-35% of either NH₄OH, NH₄NO₃, NH₄Cl or KOH. The non-abrasive solution 150 also generally has a viscosity of 1.0-2.0 cp and a pH of 2.0-13.5, and generally a pH of 9.0-13.0. In general, the non-abrasive solution 150 is selected to etch and/or oxidize the materials at the surface of the substrate assembly 12. The non-abrasive solution 150, therefore, may have compositions other than water and either ammonia or potassium hydroxide.

The lubricant-additive 160 is a separate solution or dry chemical compound that increases the viscosity of the non-abrasive solution 150 without altering the chemical effects of the non-abrasive solution 150 on the substrate assembly 12 during planarization. The lubricant-additive 160 can be glycerol, polyethylene glycol, polypropylene glycol, polyvinyl alcohol, CARBOGEL® manufactured by BF Goodrich, or POLYOX® manufactured by Union Carbide. It will be appreciated that the lubricant-additive 160 may be composed of other lubricants suitable for contact with the substrate assembly 12.

The lubricant-additive 160 is combined with the non-abrasive solution 150 to make a lubricating planarizing solution 170. The concentration of the lubricant-additive 160 in the non-abrasive solution 150 is generally selected so that the lubricating planarizing solution 170 has a viscosity of at least 4-100 cp, and more preferably 10-20 cp. The particular composition of the lubricating planarizing solution 170 will generally depend, at least in part, upon the type of abrasive particles in the pad, the shape of the raised features on the pad, and the types of material on the substrate assembly 12. The lubricating planarizing solution 170 can include the following ranges of non-abrasive solution 150 and lubricant-additive 160: (A) 90%-99.9% ammonia and water, and 0.1-10% POLYOX or CARBOGEL; or (B) 80%-95% ammonia and water, and 5-20% glycerol, polyethylene glycol or polypropylene glycol. The following compositions of lubricating planarizing solutions 170 are thus offered by way of example, not limitation:

| COMPOSITION 1 | |
|---|---|
| 0.25% weight | POLYOX |
| 99.75% weight | NH₄OH-H₂O or KOH-H₂O Solution with a pH of approximately 10-11 |

| COMPOSITION 2 | |
|---|---|
| 10% weight | Glycerol |
| 90% weight | NH₄OH-H₂O or KOH-H₂O Solution |

| COMPOSITION 3 | |
|---|---|
| 10% weight | Polyethylene Glycol |
| 90% weight | NH₄OH-H₂O or KOH-H₂O Solution |

| COMPOSITION 4 | |
|---|---|
| 5% weight | Polypropylene Glycol |
| 95% weight | NH₄OH-H₂O or KOH-H₂O Solution |

| COMPOSITION 5 | |
|---|---|
| 0.25% weight | CARBOGEL |
| 99.75% weight | NH₄OH-H₂O or KOH-H₂O Solution |

The lubricating planarizing solution 170 can be fabricated by mixing the lubricant-additive 160 with the non-abrasive solution 150 at a mixing site 114. The mixing site 114 generally provides turbulence to admix the non-abrasive solution 150 and the lubricant-additive 160. The mixing site 114, for example, can be a separate tank with an agitator (not shown), or the mixing site 114 can be a joint or an elbow in a line connecting the first container 110 to the second container 112. The mixing site 114 is coupled to the carrier head 132 by a conduit 115 to deliver the lubricating planarizing solution 170 to the nozzles 149 of the carrier head 132. The conduit 115 can be similar to those used to deliver abrasive planarizing slurries or non-abrasive planarizing solutions without lubricant-additives to web-format or rotary planarizing machines.

Figure 4 is a schematic cross-sectional view of the substrate assembly 12 being planarized on a fixed-abrasive polishing pad 40 with the lubricating planarizing solution 170. The fixed-abrasive polishing pad 40 can be substantially the same as the pad 40 described above with reference to Figure 2, and thus like reference numbers refer to like components. In operation, the lubricating planarizing solution 170 provides a protective boundary layer 172 between the front face 15 of the substrate assembly and the abrasive planarizing surface 46 at the top of the raised features. The boundary layer 172 of planarizing solution 170 separates regions of the front face 15 from the planarizing surface 46 to inhibit the fixed-abrasive particles 45 from overly abrading the front face 15. Thus, compared to planarizing solutions without the lubricant-additive 160, the lubricating planarizing solution 170 with the lubricant-additive 160 is expected to reduce defects and scratches on the front face 15 of the substrate assembly 12 in fixed-abrasive CMP processing.

From the foregoing it will be appreciated that, although specific embodiments of the invention have been described herein for purposes of illustration, various modifications may be made without deviating from the scope as defined by the appended claims. For example, the process may be implemented using a rotary planarizing machine. Suitable rotary planarizing machines are manufactured by Applied Materials, Inc., Westech Corporation, and Strasbaugh Corporation, and suitable rotary planarizing machines are described in U.S. Patent Nos. 5,456,627; 5,486,131; and 5,792,709.

## Claims

1. A method of planarizing a microelectronic-device substrate assembly, comprising:
depositing a lubricating planarizing solution without abrasive particles onto a polishing pad, the polishing pad having a body, a planarizing surface on the body, and a plurality of abrasive particles fixedly attached to the body at the planarizing surface;
pressing a front face of the substrate assembly against the lubricating planarizing solution and at least a portion of the fixed abrasive particles on the planarizing surface;
moving at least one of the polishing pad or the substrate assembly with respect to the other to impart relative motion therebetween; and
separating regions of the front face from the abrasive particles with a lubricant-additive in the lubricating planarizing solution as the substrate assembly moves relative to the polishing pad,
wherein
the lubricant―additive comprises glycerol, polypropylen glycol, polyethylene glycol or polyvinyl alcohol and depositing the lubricating solution comprises mixing the lubricant―additive into a non―abrasive solution comprising ammonia and water **characterized in that** the formed lubricating planarizing solution has a viscosity of at least 4-20 cp.

2. The method of claim 1 wherein depositing the lubricating solution comprises:
disposing the lubricating planarizing solution with the added lubricant―additiveonto the polishing pad as the substrate assembly moves relative to the polishing pad.

3. The method of claim 1 wherein depositing the lubricating solution comprises mixing the lubricant-additive into a non-abrasive solution to form a lubricating planarizing solution having a viscosity of at least 10-20 cp and disposing the lubricating planarizing solution onto the polishing pad as the substrate assembly moves relative to the polishing pad.

4. The method of claim 1 wherein:
depositing the lubricating solution comprises mixing 10% by weight of the glycerol into 90% by weight of a non-abrasive solution comprising ammonia and water to form the lubricating planarizing solution, and disposing the lubricating planarizing solution onto the polishing pad as the substrate assembly moves relative to the polishing pad.

5. The method of claim 1 wherein:
depositing the lubricating solution comprises mixing the polypropylene glycol into a non-abrasive solution comprising ammonia and water to form a lubricating planarizing solution having a viscosity of at least 4-20 cp, and disposing the lubricating planarizing solution onto the polishing pad as the substrate assembly moves relative to the polishing pad.

6. The method of claim 1 wherein:
depositing the lubricating solution comprises mixing 5% by weight of the polypropylene glycol into 95% by weight of a non-abrasive solution comprising ammonia and water to form the lubricating planarizing solution, and disposing the lubricating planarizing solution onto the polishing pad as the substrate assembly moves relative to the polishing pad.

7. The method of claim 1 wherein:
depositing the lubricating solution comprises mixing the polyethylene glycol into a non-abrasive solution comprising ammonia and water to form a lubricating planarizing solution having a viscosity of at least 4-20 cp, and disposing the lubricating planarizing solution onto the polishing pad as the substrate assembly moves relative to the polishing pad.

8. The method of claim 1 wherein:
depositing the lubricating solution comprises mixing 10% by weight of the polyethylene glycol into 90% by weight of a non-abrasive solution comprising ammonia and water to form the lubricating planarizing solution, and disposing the lubricating planarizing solution onto the polishing pad as the substrate assembly moves relative to the polishing pad.

9. The method of claim 1 wherein:
depositing the lubricating solution comprises mixing the polyvinyl alcohol into a non-abrasive solution comprising ammonia and water to form a lubricating planarizing solution having a viscosity of at least 4-100 cp, and disposing the lubricating planarizing solution onto the polishing pad as the substrate assembly moves relative to the polishing pad.

10. The method of claim 1 wherein:
depositing the lubricating solution comprises mixing 10% by weight of the polyvinyl alcohol into 90% by weight of a non-abrasive solution comprising ammonia and water to form the lubricating planarizing solution, and disposing the lubricating planarizing solution onto the polishing pad as the substrate assembly moves relative to the polishing pad.

11. A lubricating planarizing solution, comprising:
a non-abrasive solution without abrasive particles, the non-abrasive solution having a viscosity less than 4 cp; and
a lubricant-additive mixed with the non-abrasive solution, the lubricant-additive being a non-abrasive compound having a viscosity greater than 4 cp, wherein the lubricating planarizing solution does not include abrasive particles and the non-abrasive solution comprises water and ammonia; and the lubricant additive comprises glycerol, polypropylene glycol, polyethylene glycol or polyvinyl alcohol,
**characterized in that** the lubricating planarizing solution has a viscosity wherein greater than 4 cp.

12. A method of making the lubricating solution of claim 11, comprising:
providing a non-abrasive solution without abrasive particles containing at least water;
adding the lubricant―additive to the non―abrasive solution to form a non― abrasive lubricating planarizing solution without abrasive particles, and solution comprising water and ammonia to form a lubricating planarizing solution having a viscosity of at least 10 cp.

13. The method of claim12 wherein adding the lubricant-additive to the non-abrasive solution comprises mixing approximately 10% by weight of glycerol with approximately 90% by weight of a non-abrasive solution including water and ammonia.

14. The method of claim 12 wherein adding the lubricant-additive to the non-abrasive solution comprises mixing approximately 5% by weight of polypropylene glycol with approximately 95% by weight of a non-abrasive solution including water and ammonia.

15. The method of claim 12 wherein adding the lubricant-additive to the non-abrasive solution comprises mixing approximately 10% by weight of polyethylene glycol with approximately 90% by weight of a non-abrasive solution including water and ammonia.

16. The method of claim 12 wherein adding the lubricant-additive to the non-abrasive solution comprises mixing approximately 10% by weight of polyvinyl alcohol with approximately 90% by weight of a non-abrasive solution including water and ammonia.

17. A planarizing machine (10) for planarizing microelectronic-device substrate assemblies, comprising:
a support table (11);
a polishing pad (41) on the support table (11), the polishing pad having a body, a planarizing surface on the body, and a plurality of abrasive particles fixedly attached to the body at the planarizing surface;
a carrier assembly having a carrier head configured to hold a substrate assembly and a drive mechanism attached to the carrier head to move the carrier relative to the polishing pad;
a non-abrasive lubricating planarizing solution without abrasive particles on the polishing pad, **characterized in that** the lubricating planarizing solution has a viscosity of at least 4-100 cp,
a first container and a supply of a non-abrasive solution in the first container;
a second container and a supply, of a lubricant-additive in the second container; and
a mixing site coupled to the first and second containers are provided, the lubricant-additive being mixed with non-abrasive solution at the mixing site to produce said lubricating planarizing solution, and the mixing site being coupled to a nozzle to dispense the lubricating planarizing solution onto the polishing pad.

## Patentansprüche

1. Verfahren zum Planarisieren einer Träger-Baueinheit für eine mikroelektronische Vorrichtung, aufweisend:
Aufbringen einer gleitend-machenden Planarisierlösung ohne Schleifteilchen auf eine Poliermatte, wobei die Poliermatte einen Körper, eine Planarisieroberfläche auf dem Körper und eine Mehrzahl an Schleifteilchen, die an dem Körper an der Planarisieroberfläche fixiert befestigt sind, hat;
Pressen einer Vorderseite der Träger-Baueinheit gegen die gleitend-machende Planarisierlösung und mindestens einen Teil der fixierten Schleifteilchen auf der Planarisieroberfläche;
Bewegen mindestens einer der Komponenten Poliermatte oder Träger-Baueinheit bezüglich der anderen, um zwischen ihnen eine relative Bewegung zu schaffen; und
Trennen von Bereichen der Vorderseite von den Schleifteilchen mit einem Gleitmittel-Zusatz in der gleitend-machenden Planarisierlösung, während sich die Träger-Baueinheit relativ zu der Poliermatte bewegt,
wobei der Gleitmittel-Zusatz Glycerol, Polypropylenglycol, Polyethylenglycol oder Polyvinylalkohol aufweist, und wobei das Aufbringen der gleitend-machenden Lösung das Einmischen des Gleitmittel-Zusatzes in eine nicht-abrasive Lösung, die Ammoniak und Wasser enthält, aufweist,
**dadurch gekennzeichnet,**
**dass** die gebildete gleitend-machende Planarisierlösung eine Viskosität von mindestens 4 bis 20 cp hat.

2. Verfahren nach Anspruch 1, bei dem das Aufbringen der gleitend-machenden Lösung aufweist:
Auftragen der gleitend-machenden Planarisierlösung mit dem zugesetzten Gleitmittel-Zusatz auf die Poliermatte, wenn sich die Träger-Baueinheit relativ zu der Poliermatte bewegt.

3. Verfahren nach Anspruch 1, bei dem das Aufbringen der gleitend-machenden Lösung das Einmischen des Gleitmittel-Zusatzes in eine nicht-abrasive Lösung, um eine gleitend-machende Planarisierlösung mit einer Viskosität von mindestens 10 bis 20 cp zu bilden, und das Auftragen der gleitend-machenden Planarisierlösung auf die Poliermatte, wenn sich die Träger-Baueinheit relativ zu der Poliermatte bewegt, aufweist.

4. Verfahren nach Anspruch 1, bei dem:
das Aufbringen der gleitend-machenden Lösung das Einmischen von 10 Gew.-% des Glycerols in 90 Gew.-% einer nicht-abrasiven Lösung, die Ammoniak und Wasser enthält, um die gleitend-machende Planarisierlösung zu bilden, und das Auftragen der gleitend-machenden Planarisierlösung auf die Poliermatte, wenn sich die Träger-Baueinheit relativ zu der Poliermatte bewegt, aufweist.

5. Verfahren nach Anspruch 1, bei dem:
das Aufbringen der gleitend-machenden Lösung das Einmischen des Polypropylenglycols in eine nicht-abrasive Lösung, die Ammoniak und Wasser enthält, um eine gleitend-machende Planarisierlösung mit einer Viskosität von mindestens 4 bis 20 cp zu bilden, und das Auftragen der gleitend-machenden Planarisierlösung auf die Poliermatte, wenn sich die Träger-Baueinheit relativ zu der Poliermatte bewegt, aufweist.

6. Verfahren nach Anspruch 1, bei dem:
das Aufbringen der gleitend-machenden Lösung das Einmischen von 5 Gew.-% des Polypropylenglycols in 95 Gew.-% einer nicht-abrasiven Lösung, die Ammoniak und Wasser enthält, um die gleitend-machende Planarisierlösung zu bilden, und das Auftragen der gleitend-machenden Planarisierlösung auf die Poliermatte, wenn sich die Träger-Baueinheit relativ zu der Poliermatte bewegt, aufweist.

7. Verfahren nach Anspruch 1, bei dem:
das Aufbringen der gleitend-machenden Lösung das Einmischen des Polyethylenglycols in eine nicht-abrasive Lösung, die Ammoniak und Wasser enthält, um eine gleitend-machende Planarisierlösung mit einer Viskosität von mindestens 4 bis 20 cp zu bilden, und das Auftragen der gleitend-machenden Planarisierlösung auf die Poliermatte, wenn sich die Träger-Baueinheit relativ zu der Poliermatte bewegt, aufweist.

8. Verfahren nach Anspruch 1, bei dem:
das Aufbringen der gleitend-machenden Lösung das Einmischen von 10 Gew.-% des Polyethylenglycols in 90 Gew.-% einer nicht-abrasiven Lösung, die Ammoniak und Wasser enthält, um die gleitend-machende Planarisierlösung zu bilden, und das Auftragen der gleitend-machenden Planarisierlösung auf die Poliermatte, wenn sich die Träger-Baueinheit relativ zu der Poliermatte bewegt, aufweist.

9. Verfahren nach Anspruch 1, bei dem:
das Aufbringen der gleitend-machenden Lösung das Einmischen des Polyvinylalkohols in eine nicht-abrasive Lösung, die Ammoniak und Wasser enthält, um eine gleitend-machende Planarisierlösung mit einer Viskosität von mindestens 4 bis 100 cp zu bilden, und das Auftragen der gleitendmachenden Planarisierlösung auf die Poliermatte, wenn sich die Träger-Baueinheit relativ zu der Poliermatte bewegt, aufweist.

10. Verfahren nach Anspruch 1, bei dem:
das Aufbringen der gleitend-machenden Lösung das Einmischen von 10 Gew.-% des Polyvinylalkohols in 90 Gew.-% einer nicht-abrasiven Lösung, die Ammoniak und Wasser enthält, um die gleitend-machende Planarisierlösung zu bilden, und das Auftragen der gleitend-machenden Planarisierlösung auf die Poliermatte, wenn sich die Träger-Baueinheit relativ zu der Poliermatte bewegt, aufweist.

11. Gleitend-machende Planarisierlösung, aufweisend:
eine nicht-abrasive Lösung ohne Schleifteilchen, wobei die nicht-abrasive Lösung eine Viskosität von weniger als 4 cp hat; und
einen mit der nicht-abrasiven Lösung gemischten Gleitmittel-Zusatz, wobei der Gleitmittel-Zusatz eine nicht-abrasive Verbindung mit einer Viskosität von größer als 4 cp ist, wobei die gleitend-machende Planarisierlösung keine Schleifteilchen enthält und wobei die nicht-abrasive Lösung Wasser und Ammoniak enthält; und wobei der Gleitmittel-Zusatz Glycerol, Polypropylenglycol, Polyethylenglycol oder Polyvinylalkohol aufweist,
**dadurch gekennzeichnet,**
**dass** die gleitend-machende Planarisierlösung eine Viskosität von größer als 4 cp hat.

12. Verfahren zur Herstellung der gleitend-machenden Lösung nach Anspruch 11, aufweisend:
Bereitstellen einer nicht-abrasiven Lösung ohne Schleifteilchen, die mindestens Wasser enthält;
Zugeben des Gleitmittel-Zusatzes zu der nicht-abrasiven Lösung, um eine nicht-abrasive gleitend-machende Planarisierlösung ohne Schleifteilchen zu bilden, und wobei die Lösung Wasser und Ammoniak aufweist, um eine gleitend-machende Planarisierlösung mit einer Viskosität von mindestens 10 cp zu bilden.

13. Verfahren nach Anspruch 12, bei dem das Zugeben des Gleitmittel-Zusatzes zu der nicht-abrasiven Lösung das Mischen von näherungsweise 10 Gew.-% Glycerol mit näherungsweise 90 Gew.-% einer nicht-abrasiven Lösung, die Wasser und Ammoniak enthält, aufweist.

14. Verfahren nach Anspruch 12, bei dem das Zugeben des Gleitmittel-Zusatzes zu der nicht-abrasiven Lösung das Mischen von näherungsweise 5 Gew.-% Polypropylenglycol mit näherungsweise 95 Gew.-% einer nicht-abrasiven Lösung, die Wasser und Ammoniak enthält, aufweist.

15. Verfahren nach Anspruch 12, bei dem das Zugeben des Gleitmittel-Zusatzes zu der nicht-abrasiven Lösung das Mischen von näherungsweise 10 Gew.-% Polyethylenglycol mit näherungsweise 90 Gew.-% einer nicht-abrasiven Lösung, die Wasser und Ammoniak enthält, aufweist.

16. Verfahren nach Anspruch 12, bei dem das Zugeben des Gleitmittel-Zusatzes zu der nicht-abrasiven Lösung das Mischen von näherungsweise 10 Gew.-% Polyvinylalkohol mit näherungsweise 90 Gew.-% einer nicht-abrasiven Lösung, die Wasser und Ammoniak enthält, aufweist.

17. Planarisiermaschine (10) zum Planarisieren von Träger-Baueinheiten für mikroelektronische Vorrichtungen, aufweisend:
einen Auflagetisch (11);
eine Poliermatte (41) auf dem Auflagetisch (11), wobei die Poliermatte einen Körper, eine Planarisieroberfläche auf dem Körper und eine Mehrzahl an Schleifteilchen, die an dem Körper an der Planarisieroberfläche fixiert befestigt sind, hat;
ein Haltesystem mit einem Haltekopf, der zum Festhalten einer Träger-Baueinheit gestaltet ist, und einem Antriebsmechanismus, der mit dem Haltekopf verbunden ist, um den Halter relativ zu der Poliermatte zu bewegen;
eine nicht-abrasive gleitend-machende Planarisierlösung ohne Schleifteilchen auf der Poliermatte,
**dadurch gekennzeichnet,**
**dass** die gleitend-machende Planarisierlösung eine Viskosität von mindestens 4 bis 100 cp hat,
ein erster Behälter und ein Vorrat an einer nicht-abrasiven Lösung in dem ersten Behälter;
ein zweiter Behälter und ein Vorrat an einem Gleitmittel-Zusatz in dem zweiten Behälter; und
eine mit dem ersten und dem zweiten Behälter verbundene Misch-Stelle vorgesehen sind, wobei der Gleitmittel-Zusatz an der Misch-Stelle mit nichtabrasiver Lösung gemischt wird, um die gleitend-machende Planarisierlösung zu erzeugen, und die Misch-Stelle mit einer Düse verbunden ist, um die gleitend-machende Planarisierlösung auf der Poliermatte zu verteilen.

## Revendications

1. Procédé d'aplanissement d'un assemblage de substrat de dispositifs microélectroniques comprenant les étapes consistant à :
déposer une solution d'aplanissement lubrifiante sans particules abrasives sur un tampon de polissage, le tampon de polissage comprenant un corps, une surface d'aplanissement sur le corps, et une pluralité de particules abrasives fixées solidement sur le corps au niveau de la surface d'aplanissement ;
comprimer une face antérieure de l'assemblage de substrat contre la solution d'aplanissement lubrifiante et au moins une partie des particules abrasives fixes sur la surface d'aplanissement ;
déplacer au moins un parmi le tampon de polissage ou l'assemblage de substrat par rapport à l'autre pour communiquer un mouvement relatif entre les deux ; et
séparer des zones de la face antérieure des particules abrasives avec un additif lubrifiant dans la solution d'aplanissement lubrifiante lorsque l'assemblage de substrat se déplace par rapport au tampon de polissage,
dans lequel
l'additif lubrifiant comprend du glycérol, du propylène glycol, du polyéthylène glycol ou de l'alcool polyvinylique et le dépôt de la solution lubrifiante comprend l'étape consistant à mélanger l'additif lubrifiant dans une solution non abrasive comprenant de l'ammonium et de l'eau **caractérisé en ce que** la solution d'aplanissement lubrifiante formée présente une viscosité d'au moins 4 à 20 cp.

2. Procédé selon la revendication 1, dans lequel le dépôt de la solution lubrifiante comprend l'étape consistant à :
disposer la solution d'aplanissement lubrifiante avec l'additif lubrifiant ajouté sur le tampon de polissage lorsque l'assemblage de substrat se déplace par rapport au tampon de polissage.

3. procédé selon la revendication 1, dans lequel le dépôt de la solution lubrifiante comprend les étapes consistant à mélanger l'additif lubrifiant dans une solution non abrasive pour former une solution d'aplanissement lubrifiante présentant une viscosité d'au moins 10 à 20 cp et disposer la solution d'aplanissement lubrifiante sur le tampon de polissage comme l'assemblage de substrat se déplace par rapport au tampon de polissage.

4. Procédé selon la revendication 1, dans lequel :
le dépôt de la solution lubrifiante comprend les étapes consistant à mélanger 10 % en masse du glycérol dans 90 % en masse d'une solution non abrasive comprenant de l'ammonium et de l'eau pour former la solution d'aplanissement lubrifiante, et disposer la solution d'aplanissement lubrifiante sur le tampon de polissage lorsque l'assemblage de substrat se déplace par rapport au tampon de polissage.

5. Procédé selon la revendication 1, dans lequel :
le dépôt de la solution lubrifiante comprend les étapes consistant à mélanger le polypropylène glycol dans une solution non abrasive comprenant de l'ammonium et de l'eau pour former une solution d'aplanissement lubrifiante présentant une viscosité d'au moins 4 à 20 cp, et disposer la solution d'aplanissement lubrifiante sur le tampon de polissage lorsque l'assemblage de substrat se déplace par rapport au tampon de polissage.

6. Procédé selon la revendication 1, dans lequel :
le dépôt de la solution lubrifiante comprend les étapes consistant à mélanger 5 % en masse du polypropylène glycol dans 95 % en masse d'une solution non abrasive comprenant de l'ammonium et de l'eau pour former la solution d'aplanissement lubrifiante, et disposer la solution d'aplanissement lubrifiante sur le tampon de polissage lorsque l'assemblage de substrat se déplace par rapport au tampon de polissage.

7. Procédé selon la revendication 1, dans lequel :
le dépôt de la solution lubrifiante comprend les étapes consistant à mélanger le polyéthylène glycol dans une solution non abrasive comprenant de l'ammonium et de l'eau pour former une solution d'aplanissement lubrifiante présentant une viscosité d'au moins 4 à 20 cp, et disposer la solution d'aplanissement lubrifiante sur le tampon de polissage.

8. Procédé selon la revendication 1, dans lequel :
le dépôt de la solution lubrifiante comprend les étapes consistant à mélanger 10 % en masse du polyéthylène glycol dans 90 % en masse d'une solution non abrasive comprenant de l'ammonium et de l'eau pour former la solution d'aplanissement lubrifiante, et disposer la solution d'aplanissement lubrifiante sur le tampon de polissage lorsque l'assemblage de substrat se déplace par rapport au tampon de polissage.

9. Procédé selon la revendication 1, dans lequel :
le dépôt de la solution lubrifiante comprend les étapes consistant à mélanger l'alcool polyvinylique dans une solution non abrasive comprenant de l'ammonium et de l'eau pour former une solution d'aplanissement lubrifiante présentant une viscosité d'au moins 4 à 100 cp, et disposer la solution d'aplanissement lubrifiante sur le tampon de polissage lorsque l'assemblage de substrat se déplace par rapport au tampon de polissage.

10. Procédé selon la revendication 1, dans lequel :
le dépôt de la solution lubrifiante comprend les étapes consistant à mélanger 10 % en masse de l'alcool polyvinylique dans 90 % en masse d'une solution non abrasive comprenant de l'ammonium et de l'eau pour former la solution d'aplanissement lubrifiante, et disposer la solution d'aplanissement lubrifiante sur le tampon de polissage lorsque l'assemblage de substrat se déplace par rapport au tampon de polissage.

11. Solution d'aplanissement lubrifiante, comprenant :
une solution non abrasive sans particules abrasives, la solution non abrasive présentant une viscosité inférieure à 4 cp ; et
un additif lubrifiant mélangé avec la solution non abrasive, l'additif lubrifiant étant un composé non abrasif présentant une viscosité supérieure à 4 cp, dans lequel la solution d'aplanissement lubrifiante ne comprend pas de particules abrasives et dans laquelle
la solution non abrasive comprend de l'eau et de l'ammonium ; et
l'additif lubrifiant comprend du glycérol, du polypropylène glycol, du polyéthylène glycol ou de l'alcool polyvinylique,
**caractérisée en ce que** la solution d'aplanissement lubrifiante présente une viscosité supérieure à 4 cp.

12. Procédé de fabrication de la solution lubrifiante selon la revendication 11, comprenant les étapes consistant à :
fournir une solution non abrasive sans particules abrasives contenant au moins de l'eau ;
ajouter l'additif lubrifiant à la solution non abrasive pour former une solution d'aplanissement lubrifiante abrasive sans particules abrasives, et une solution comprenant de l'eau et de l'ammonium pour former une solution d'aplanissement lubrifiante présentant une viscosité d'au moins 10 cp.

13. Procédé selon la revendication 12, dans lequel l'ajout d'additif lubrifiant à la solution non abrasive comprend les étapes consistant à mélanger environ 10 % en masse de glycérol avec environ 90 % en masse d'une solution non abrasive comprenant de l'eau et de l'ammonium.

14. Procédé selon la revendication 12, dans lequel l'ajout d'additif lubrifiant à la solution non abrasive comprend l'étape consistant à mélanger environ 5 % en masse de polypropylène glycol avec environ 95 % en masse d'une solution non abrasive comprenant de l'eau et de l'ammonium.

15. Procédé selon la revendication 12, dans lequel l'ajout d'additif lubrifiant à la solution non abrasive comprend l'étape consistant à mélanger environ 10 % en masse de polyéthylène glycol avec environ 90 % en masse d'une solution non abrasive comprenant de l'eau et de l'ammonium.

16. Procédé selon la revendication 12 dans lequel l'ajout d'additif lubrifiant à la solution non abrasive comprend l'étape consistant à mélanger environ 10 % en masse d'alcool polyvinylique avec environ 90 % en masse d'une solution non abrasive comprenant de l'eau et de l'ammonium.

17. Machine d'aplanissement 10 destiné à aplanir des assemblages de substrat de dispositif microélectronique, comprenant :
une table de support 11 ;
un tampon de polissage 41 sur la table de support 11, le tampon de polissage comprenant un corps, une surface d'aplanissement sur le corps, et une pluralité de particules abrasives fixées solidement au corps au niveau de la surface d'aplanissement ;
un ensemble formant chariot comprenant une tête de chariot configurée pour maintenir un assemblage de substrat et un mécanisme de commande fixé à la tête de chariot pour déplacer le chariot par rapport au tampon de polissage ;
une solution d'aplanissement lubrifiante non abrasive sans particules abrasives sur le tampon de polissage, **caractérisée en ce que** la solution d'aplanissement lubrifiante présente une viscosité d'au moins 4 à 100 cp,
un premier conteneur et une alimentation d'une solution non abrasive dans le premier conteneur ;
un deuxième conteneur et une alimentation d'un additif lubrifiant dans le deuxième conteneur ; et
un site de mélange couplé aux premier et deuxième conteneurs sont prévus, l'additif lubrifiant étant mélangé avec une solution non abrasive au niveau du site de mélange pour produire ladite solution d'aplanissement lubrifiante, et le site de mélange étant couplé à une buse pour distribuer la solution d'aplanissement lubrifiante sur le tampon de polissage.
